# DEMANDE DE BREVET EUROPEEN

(11) **EP 3 863 041 A1**
(43) Date de publication de la demande: **11.08.2021**
(21) Numéro de dépôt: 21154791.4
(22) Date de dépôt: 02.02.2021
(51) Int. Cl.: H01L 21/02, H01L 21/268, H01L 21/322, H01L 21/762, H01L 21/265

(54) **PROCÉDÉ DE FABRICATION D'UN SUBSTRAT STRUCTURÉ**

(30) Priorité: 04.02.2020 FR 2001082
(71) Demandeur: Commissariat à l'énergie atomique et aux énergies alternatives, 75015 Paris (FR)
(72) Inventeur: COLINGE, Jean-Pierre, 38054 GRENOBLE CEDEX 09 (FR)
(74) Mandataire: Brevalex

(57) **Abrégé**

L'invention concerne un procédé de fabrication d'un substrat structuré (10) pourvu d'une couche de piégeage (30') sur laquelle repose un empilement formé d'une couche isolante (30) et d'une couche de matériau monocristallin (40), le procédé comprenant les étapes suivantes :
a) une étape de formation d'une couche de silicium amorphe qui sur une face avant (21) d'un substrat de silicium (20),
b) une étape de traitement thermique destinée à convertir la couche de silicium amorphe (25) en une couche de piégeage (30') formée de grains monocristallins de silicium, les conditions de traitement thermique en termes de durée et de température étant ajustées pour limiter les grains à une taille inférieure à 200 nm,
c) une étape de formation d'un empilement en recouvrement de la couche de piégeage (30'), et formé d'une couche isolante (30) et d'une couche de matériau monocristallin (40).

## Description

### DOMAINE TECHNIQUE

L'invention concerne le domaine des substrats pour la micro-électronique et la radiofréquence (« RF »). En particulier, la présente invention concerne le domaine des substrats de silicium sur isolant (« SOI »), et notamment pourvus d'une couche de piégeage intercalée entre un substrat support et un empilement formé d'une couche isolante et d'une couche de silicium.

La présente invention vise, à cet égard, à proposer un procédé de fabrication d'un substrat de SOI HR permettant de limiter l'épaisseur de la couche de piégeage tout en conservant une densité de défauts suffisamment importante pour réduire, voire supprimer, des phénomènes parasites susceptibles d'intervenir au niveau dispositifs HR formés dans ou sur ledit substrat SOI HR.

### ÉTAT DE LA TECHNIQUE ANTÉRIEURE

Les substrats de silicium sur isolant (« SOI » ou « Silicon On Insulator » selon la terminologie Anglo-Saxonne) sont aujourd'hui largement utilisés, et depuis de nombreuses années, pour la fabrication de dispositifs micro-électroniques.

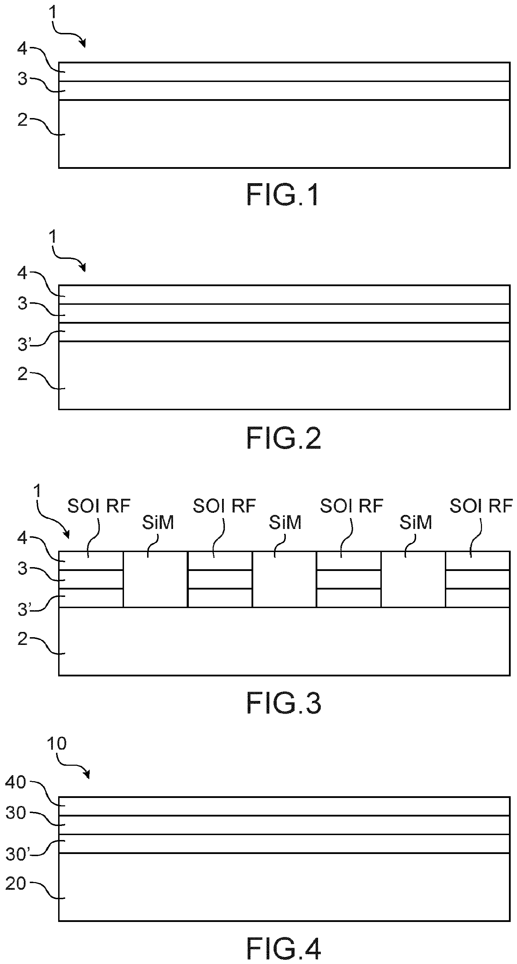

Ces substrats 1 comprennent une couche isolante 3, intercalée entre une couche de silicium 4 et un substrat support 2, destinée à isoler électriquement les composants (notamment les transistors) d'un même dispositif micro-électronique (figure 1).

Cependant dès lors qu'il s'agit de fabriquer des dispositifs radiofréquence (ci-après « RF »), par exemple pour des applications mobiles et notamment de téléphonie mobile, cette seule couche isolante ne suffit plus à assurer un fonctionnement optimal desdits dispositifs. En effet, ces derniers, lorsqu'ils fonctionnent, sont le siège de phénomènes parasites qui perturbent leur fonctionnement et affectent *de facto* leurs performances. Parmi les phénomènes parasites susceptibles d'être observés, les diaphonies, les non-linéarités, ou encore les courants de Foucault (« Eddy Currents » selon la terminologie Anglo-Saxonne) sont les plus courants.

Afin de pallier ce problème, il est proposé, dans le document US5773151, un nouveau type de substrat SOI, dit substrat SOI RF, et dans lequel une couche de piégeage 3' (« Trap-Rich layer » selon la terminologie Anglo-Saxonne) est intercalée entre la couche isolante 3 et le substrat support 2. La couche de piégeage 3' comprend à cet égard du silicium poly-cristallin. En d'autres termes, la couche de silicium poly-cristallin comprend des grains de silicium monocristallin liés entre eux par des joints de grains.

L'efficacité de cette couche de piégeage 3' à réduire, voire à supprimer, les phénomènes parasites est intimement liée à sa densité de défauts. Plus particulièrement, plus la densité de défauts est importante, meilleure est l'efficacité de la couche de piégeage 3' à réduire les phénomènes parasites au sein d'un dispositif RF.

Il est à cet égard connu que lesdits pièges sont essentiellement localisés au niveau des joints de grains de la couche de piégeage 3', de sorte que leur densité diminue à mesure que la taille des grains formant la couche de piégeage 3' augmente.

Cependant, les méthodes actuellement mises en œuvre pour la formation du silicium poly-cristallin ne permettent pas de former des grains d'une taille inférieure à environ 1 µm. En d'autres termes, la couche de piégeage afin de présenter une efficacité optimale doit être d'une épaisseur supérieure à 1 µm.

Ce dernier aspect n'est toutefois pas satisfaisant.

En effet, la considération d'une couche de piégeage 3' d'une épaisseur aussi importante est susceptible de générer des contraintes dans le substrat SOI RF, et par voie de conséquence affecter le fonctionnement du ou des dispositifs RF formés sur ou dans ledit substrat.

Par ailleurs, les substrats SOI RF semblent être des candidats de choix pour la co-intégration de dispositifs RF et digitaux par exemple. Cette co-intégration nécessite toutefois de ménager sur un même substrat des zones de SOI RF, et des zones de silicium massif SiM tel que représenté à la figure 3. La formation de ces zones de silicium massif SiM requiert de procéder à une gravure localisée de l'empilement formé par la couche de silicium 4, la couche isolante 3, et la couche de piégeage 3', et de combler le vide laissé vacant par croissance par épitaxie de silicium monocristallin.

Toutefois, la considération d'une couche de piégeage d'une épaisseur supérieure à 1 µm rend l'exécution des étapes gravure et d'épitaxie délicates et longues.

Ainsi, un but de la présente invention est de proposer un procédé de fabrication d'un substrat SOI pourvu d'une couche de piégeage, et permettant à cette dernière d'être d'une épaisseur plus faible tout en conservant une densité de défauts suffisante pour supprimer les phénomènes parasites décrits ci-avant.

Un autre but de la présente invention est de proposer un procédé de fabrication d'un substrat SOI pourvu d'une couche de piégeage qui permet une co-intégration plus facile au regard des procédés connus de l'état de la technique.

### EXPOSÉ DE L'INVENTION

Les buts de l'invention sont, au moins en partie, atteints par un procédé de fabrication d'un substrat pourvu d'une couche de piégeage sur laquelle repose un empilement formé, dans l'ordre et à partir de ladite couche de piégeage, d'une couche isolante et d'une couche de matériau monocristallin, le procédé comprenant les étapes suivantes :
a) une étape de formation d'une couche de silicium amorphe qui s'étend à partir d'une face avant d'un substrat de silicium selon une épaisseur E inférieure à 500 nm, avantageusement comprise entre 50 nm et 200 nm,
b) une étape de traitement thermique destinée à convertir la couche de silicium amorphe en une couche de piégeage formée de grains monocristallins de silicium soudés entre eux par des joints de grains et d'une taille inférieure à 200 nm, de préférence inférieure à 100 nm,
c) une étape de formation d'un empilement en recouvrement de la couche de piégeage, et formé, dans l'ordre et à partir de ladite couche de piégeage, d'une couche isolante et d'une couche de matériau monocristallin.

Selon un mode de réalisation, les conditions de traitement thermique de l'étape b) en termes de durée et de température sont ajustées de manière à limiter la taille T des grains à une taille inférieure à 200 nm, de préférence inférieure à 100 nm

Selon un mode de réalisation, l'étape b) est exécutée au moyen d'un rayonnement laser, avantageusement le rayonnement laser est un rayonnement laser à impulsions dont les impulsions sont d'une durée comprise entre 1 nanoseconde et 1 microseconde, d'une fluence comprise entre 10 J/cm² et 300 J/cm², et d'une longueur d'onde comprise entre 200 nanomètres et 1100 nanomètres.

Selon un mode de réalisation, la couche de silicium amorphe est formée, lors de l'étape a), par dépôt, et notamment par dépôt en phase vapeur à basse pression.

Selon un mode de réalisation, la couche de silicium amorphe est formée, lors de l'étape a), par une implantation d'amorphisation, d'espèces amorphisantes, destinée à amorphiser le substrat de silicium à partir de sa face avant et selon une profondeur d'implantation égale à l'épaisseur E.

Selon un mode de réalisation, les espèces amorphisantes comprennent :
- des ions germanium, de sorte que lors l'étape b) de traitement thermique de l'oxyde de germanium se forme au niveau des joints de grains,
   et/ou
- des ions carbone destinés à favoriser également la formation de grains de taille T inférieure à 200 nm, de préférence inférieure à 100 nm, lors de l'exécution de l'étape b),
   et/ou
- des espèces présentant une affinité chimique avec le silicium de manière à former avec ce dernier des précipités ou des complexes s'agrégeant au niveau des joints de grains lors de l'exécution de l'étape b), lesdites espèces comprenant en particulier des ions oxygène et/ou des ions azote.

Selon un mode de réalisation, l'étape b) est précédée d'une étape a3) d'aplanissement de la couche de silicium amorphe, l'étape a3) étant avantageusement exécutée par polissage mécanochimique.

Selon un mode de réalisation, lors de l'exécution de l'étape c), la formation de la couche de matériau monocristallin comprend un report de ladite couche de matériau monocristallin à partir d'un substrat donneur.

Selon un mode de réalisation, le report comprend dans l'ordre :
- un assemblage du substrat donneur et du substrat de silicium monocristallin,
- un amincissement du substrat donneur de manière à ne conserver que la couche de matériau cristallin sur le substrat de silicium monocristallin.

Selon un mode de réalisation, l'amincissement du substrat donneur comprend un amincissement par abrasion mécanique.

Selon un mode de réalisation, l'assemblage du substrat donneur et du substrat de silicium est précédé de la formation d'une zone de fragilisation qui délimite la couche de matériau monocristallin au sein du substrat donneur, avantageusement la zone de fragilisation est formée par implantation d'espèces chimique, et notamment par implantation d'hydrogène et/ou d'hélium.

Selon un mode de réalisation, l'amincissement comprend une fracture qui se propage le long de la zone de fragilisation, ladite fracture étant avantageusement initiée par un second traitement thermique.

Selon un mode de réalisation, l'assemblage est précédé de la formation de la couche isolante sur l'une et/ou l'autre de la couche de piégeage et de la couche de matériau monocristallin.

Selon un mode de réalisation, la couche de matériau monocristallin comprend au moins un des éléments choisi parmi : silicium, germanium, alliage de silicium-germanium, carbure de silicium, un semi-conducteur III-V, un matériau piézoélectrique.

L'invention concerne aussi un substrat structuré qui comprend :
- un couche de piégeage qui s'étend à partir d'une face avant d'un substrat de silicium selon une épaisseur E inférieure à 500 nm, avantageusement comprise entre 50 nm et 200 nm, la couche de piégeage comprenant des grains monocristallins de silicium soudés entre eux par des joints de grains, et d'une taille T inférieure à 200 nm, voire 100 nm,
- un empilement formé, dans l'ordre et à partir de ladite couche de piégeage, d'une couche isolante et d'une couche de matériau monocristallin.

### BRÈVE DESCRIPTION DES DESSINS

D'autres caractéristiques et avantages apparaîtront dans la description qui va suivre d'un procédé de fabrication d'un substrat structuré selon l'invention, donnés à titre d'exemples non limitatifs, en référence aux dessins annexés dans lesquels :
La figure 1 est une représentation schématique d'un substrat SOI connu de l'état de la technique et dépourvu de couche de piégeage, le substrat SOI est notamment représenté selon un plan de coupe perpendiculaire à une face principale du dudit substrat SOI ;
La figure 2 est représentation schématique d'un substrat SOI RF de l'état de la technique et pourvu d'une couche de piégeage intercalée entre la couche d'isolant et le substrat support, le substrat SOI RF est notamment représenté selon un plan de coupe perpendiculaire à une face principale du dudit substrat SOI ;
La figure 3 est représentation schématique du substrat SOI RF de la figure 2, et sur lequel des zones de silicium massif ont été formées ;
La figure 4 est une représentation schématique d'un substrat structuré obtenu par le procédé de fabrication selon la présente invention, le substrat structuré est notamment représenté selon un plan de coupe perpendiculaire audit substrat ;
La figure 5 est une représentation schématique de l'exécution de l'étape a) selon une première alternative de la présente invention, le substrat de silicium mono cristallin étant représenté selon un plan de coupe perpendiculaire à la face avant dudit substrat ;
La figure 6 est une représentation schématique de l'exécution de l'étape a) selon une deuxième alternative de la présente invention, le substrat de silicium mono cristallin étant représenté selon un plan de coupe perpendiculaire à la face avant dudit substrat ;
La figure 7 est une représentation schématique de l'exécution de l'étape b) selon la présente invention, le substrat de silicium cristallin étant représenté selon un plan de coupe perpendiculaire à la face avant dudit substrat ;
La figure 8 est une représentation schématique d'un substrat donneur sur une face principale duquel reposent dans l'ordre la couche de matériau monocristallin et la couche isolante ;
La figure 9 est une représentation schématique d'une étape d'assemblage exécutée lors du report d'une couche de matériau monocristallin et d'une couche isolante susceptible d'être mise en œuvre dans le cadre de la présente invention ;
La figure 10 est une représentation schématique d'une étape d'amincissement exécutée lors du report d'une couche de matériau monocristallin et d'une couche isolante susceptible d'être mise en œuvre dans le cadre de la présente invention ;
La figure 11 est une représentation schématique d'une étape de formation d'une zone de fragilisation exécutée pour le report d'une couche de matériau monocristallin et d'une couche isolante, et susceptible d'être mise en œuvre dans le cadre de la présente invention ;
La figure 12 est une représentation schématique d'une étape d'assemblage considérant la couche isolante formée en recouvrement de la couche de piégeage avant ledit assemblage et susceptible d'être mise en œuvre dans le cadre de la présente invention ;
La figure 13 est une représentation schématique d'une étape d'assemblage considérant la couche isolante comprenant un empilement pourvu d'une première couche isolante et d'une deuxième couche isolante formée en recouvrement, respectivement, de la couche de matériau monocristallin et de la couche de piégeage avant ledit assemblage et susceptible d'être mise en œuvre dans le cadre de la présente invention.

### EXPOSÉ DÉTAILLÉ DE MODES DE RÉALISATION PARTICULIERS

La présente demande concerne un procédé de fabrication d'un substrat structuré, et notamment d'un substrat qui comprend d'une face avant vers une face arrière, une couche de matériau monocristallin, une couche d'isolant, une couche de piégeage, et un substrat support.

En particulier, le procédé selon la présente invention permet de former une couche de piégeage formée de grains monocristallins de silicium soudés entre eux par des joints de grains, et dont la taille T est inférieure à 200 nm, voire 100 nm.

A cette fin, le procédé met en œuvre la formation d'une couche de silicium amorphe qui est convertie en la couche de piégeage par exécution d'un recuit thermique dans des conditions appropriées en termes de durée et de température. La combinaison avantageuse de ces deux conditions permet alors de former une couche de piégeage d'une épaisseur relativement faible, et notamment inférieure à 500 nm, tout en présentant une densité de défauts relativement importante.

A la figure 4, on peut voir une représentation schématique d'un substrat structuré 10 selon la présente invention.

Le substrat structuré 10 comprend notamment :
- une couche de piégeage 30' qui s'étend à partir d'une face avant d'un substrat de silicium 20 selon une épaisseur E inférieure à 500 nm, avantageusement comprise entre 50 nm et 200 nm, la couche de piégeage 30' comprenant des grains monocristallins de silicium soudés entre eux par des joints de grains, et d'une taille T inférieure à 200 nm, voire 100 nm,
- un empilement formé, dans l'ordre et à partir de ladite couche de piégeage, d'une couche isolante 30 et d'une couche de matériau monocristallin 40.

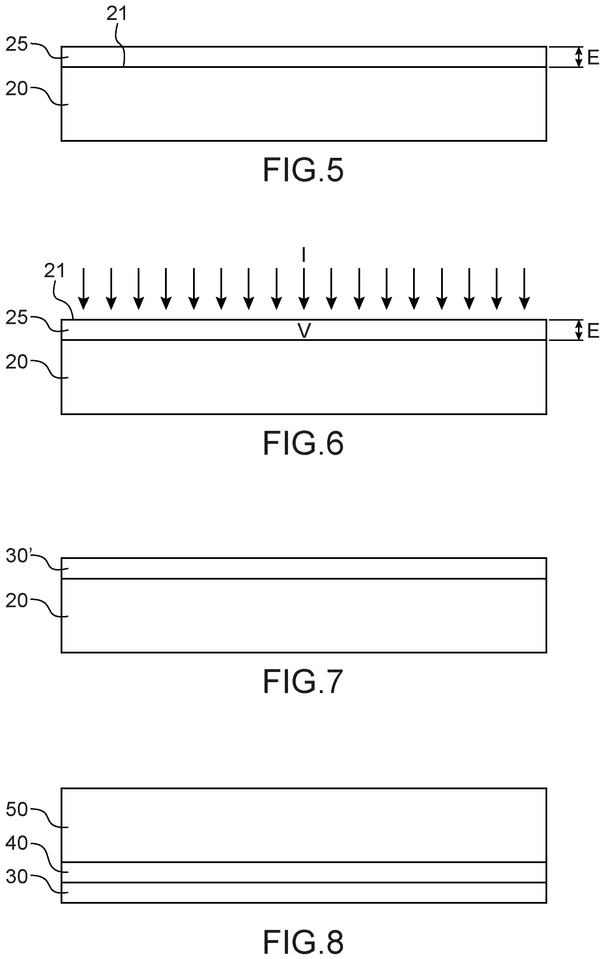

Les figures 5 à 13 sont des représentations schématiques des différentes étapes susceptibles d'être mises en œuvre pour la fabrication d'un substrat structuré 10 selon la présente invention.

Le procédé de fabrication comprend une étape a) de formation d'une couche de silicium amorphe 25. En particulier, la couche de silicium amorphe 25 est formé dans ou sur un substrat de silicium 20, et s'étend à partir d'une face avant 21 dudit substrat de silicium.

Plus particulièrement, la couche de silicium amorphe 25 présente une épaisseur E inférieure à 500 nm, voire comprise entre 50 nm et 200 nm, par exemple égale à 100 nm.

Tel qu'illustré à la figure 5, et selon une première variante, la couche de silicium amorphe 25 peut être formée par dépôt, et notamment par dépôt en phase vapeur à basse pression (« LPCVD » ou « Low Pressure Chemical Vapor Déposition » selon la terminologie Anglo-Saxonne), directement sur la face avant 21 du substrat de silicium.

Le dépôt LPCVD peut notamment mettre œuvre comme précurseur du silane, et être exécuté à une température comprise entre 480 et 600°C.

Selon une deuxième alternative, illustrée à la figure 6, la couche de silicium amorphe peut être formée dans un volume V du substrat de silicium 20 qui s'étend, à partir de la face avant 21, selon une profondeur égale à l'épaisseur E.

Cette seconde alternative peut notamment mettre en œuvre une implantation I, dite implantation d'amorphisation, d'espèces amorphisantes de manière à amorphiser le volume V du substrat de silicium 20.

Les espèces implantées lors de l'implantation I peuvent notamment comprendre des ions germanium ou des ions silicium.

L'invention n'est toutefois pas limitée à ces seules espèces, et l'homme du métier pourra choisir tout autre ion susceptible de convenir pour la mise en œuvre de cette étape d'amorphisation.

A titre d'exemple, l'implantation peut mettre en œuvre une implantation d'ions germanium dont la dose est comprise entre 10¹⁶ cm⁻² et 10¹⁷ cm⁻², et la profondeur d'implantation est comprise entre 50 nm et 500 nm. L'implantation du germanium peut également être exécutée en plusieurs étapes, à des énergies et des doses d'implantation différentes, de manière à étaler la zone implantée.

De manière alternative ou complémentaire, les espèces amorphisantes peuvent comprendre des ions carbone.

Toujours de manière alternative et/ou complémentaire, les espèces amorphisantes peuvent comprendre des espèces présentant une affinité chimique avec le silicium, de manière à former avec ce dernier des précipités ou des complexes, et notamment des précipités ou des complexes s'agrégeant au niveau des joints de grains lors de l'exécution d'une recristallisation par traitement thermique de la couche de silicium amorphe 25.

L'étape a) du procédé de fabrication d'un substrat structuré est alors suivie d'une étape b) (figure 7) de traitement thermique destinée à recristalliser la couche de silicium amorphe et ainsi la convertir en une couche de piégeage 30' formée de grains monocristallins de silicium soudés entre eux par des joints de grains. Les conditions de traitement thermique en termes de durée et de température sont ajustées pour limiter la taille T des grains à une taille inférieure à 200 nm, voire 100 nm. Ce traitement peut faire appel à un recuit dit « Flash », et notamment mettre en œuvre un dispositif laser qui peut en un très court lapse de temps chauffer localement le silicium amorphe de manière à le transformer silicium poly cristallin. Le recuit « Flash » peut être effectué par l'utilisation d'un système à chauffage par lampe flash (durée : quelques millisecondes), ou par un recuit par laser « nanoseconde » (durée comprise entre 1 ns et 1 µs). La rapidité d'exécution d'un tel chauffage localisé favorise la formation de grains monocristallins bien plus petits que ceux obtenus par des techniques de recuit conventionnelles telles que les recuits thermiques rapides.

À titre d'exemple, l'étape b) met en œuvre un rayonnement laser à impulsions dont les impulsions sont d'une durée comprise entre 1 nanoseconde et 1 microseconde, d'une fluence comprise entre 10 J/cm² et 300 J/cm², et d'une longueur d'onde comprise entre 200 nanomètres et 1100 nanomètres.

Le laser employé pour ce type de recuit peut être un laser à impulsion, notamment un laser excimère du type KrF. On peut également utiliser un laser Nd :YAG dont la longueur d'onde est 1,06 µm. L'homme du métier souhaitant mettre en œuvre une étape b) avec un dispositif Laser pourra consulter le document [1] cité à la fin de la description.

Il par ailleurs notable qu'une étape a) exécutée selon la deuxième alternative par implantation d'amorphisation d'ions germanium aura un effet particulièrement avantageux lors de l'exécution du l'étape b) de traitement thermique. En effet, les ions germanium susceptibles d'être implantés formeront, lors de l'exécution de l'étape b), de l'oxyde de germanium qui favorise la formation de petits grains. En outre, l'oxyde de germanium formé lors de l'exécution de l'étape b) se concentre au niveau de joints de grains et vient par voie de conséquence figer la croissance de ces derniers.

Une implantation d'amorphisation mettant en œuvre des ions carbone permet également de favoriser la formation de grains de taille T inférieure à 200 nm, de préférence inférieure à 100 nm, lors de l'exécution de l'étape b). La dose d'ions carbone implantés peut par exemple être comprise entre 10¹⁴ cm⁻² et 10¹⁶ cm⁻² et à une énergie comprise entre 15 keV et 150 keV.

Une implantation amorphisante mettant en œuvre des espèces présentant une affinité chimique avec le silicium, permettra de former avec ce dernier des précipités ou des complexes, et notamment des précipités ou des complexes s'agrégeant au niveau des joints de grains lors de l'exécution de l'étape b).

Ce dernier aspect est également extrêmement avantageux dans la mesure où des précipités et/ou complexes vont se concentrer au niveau des joints de grains lors de l'exécution de l'étape b) et ainsi augmenter la densité de défauts. En d'autres termes cette implantation permet d'améliorer la capacité de piégeage de la couche de piégeage 30'. Des espèces de choix sont par exemple les ions oxygène et/ou les ions azote. La dose de ces espèces implantés peut par exemple être comprise entre 10¹⁴ cm⁻² et 10¹⁶ cm⁻² et à une énergie comprise entre 15 keV et 150 keV.

L'étape b) de traitement thermique peut être directement suivie d'une étape b1) de polissage mécano-chimique (« CMP » ou « Chemical Mechanical Polishing » selon la terminologie Anglo-Saxonne). Cette étape de CMP peut notamment être mise en œuvre pour préparer (lisser) la surface exposée de la couche de piégeage 30' avant une étape d'assemblage qui sera présentée dans la suite de l'énoncé de la présente invention.

Le procédé selon la présente invention comprend enfin une étape c) de formation d'un empilement en recouvrement de la couche de piégeage 30', et formé, dans l'ordre et à partir de ladite couche de piégeage 30', d'une couche isolante 30 et d'une couche de matériau monocristallin 40.

La couche de matériau monocristallin peut comprendre au moins un des éléments choisi parmi : silicium, germanium, alliage de silicium-germanium, carbure de silicium, un semi-conducteur III-V, un matériau piézoélectrique.

L'étape c) peut notamment comprendre un report de ladite couche de matériau monocristallin à partir d'un substrat donneur 50.

Plus particulièrement, et selon un mode de réalisation particulièrement avantageux, l'étape c) comprend le report de l'empilement formé par la couche isolante 30 et la couche de matériau monocristallin 40 à partir du substrat donneur 50.

En d'autres termes la couche isolante 30 peut être formée en recouvrement de la couche de matériau monocristallin 40 formée sur ou dans le substrat donneur 50 (figure 8).

Par exemple, la couche isolante 30 comprend de l'oxyde de silicium, par exemple déposé selon une technique de dépôt conventionnelle. Il peut, à cet égard, s'agir d'une couche de silicium formée par dépôt en phase vapeur activée par plasma (« PECVD » ou « Plasma Enhanced Chemical Vapor Déposition » selon la terminologie Anglo-Saxonne), et mettant en œuvre du TEOS comme précurseur. Alternativement, si le substrat donneur est un substrat de silicium monocristallin, la couche isolante peut être obtenue par oxydation thermique de ce dernier.

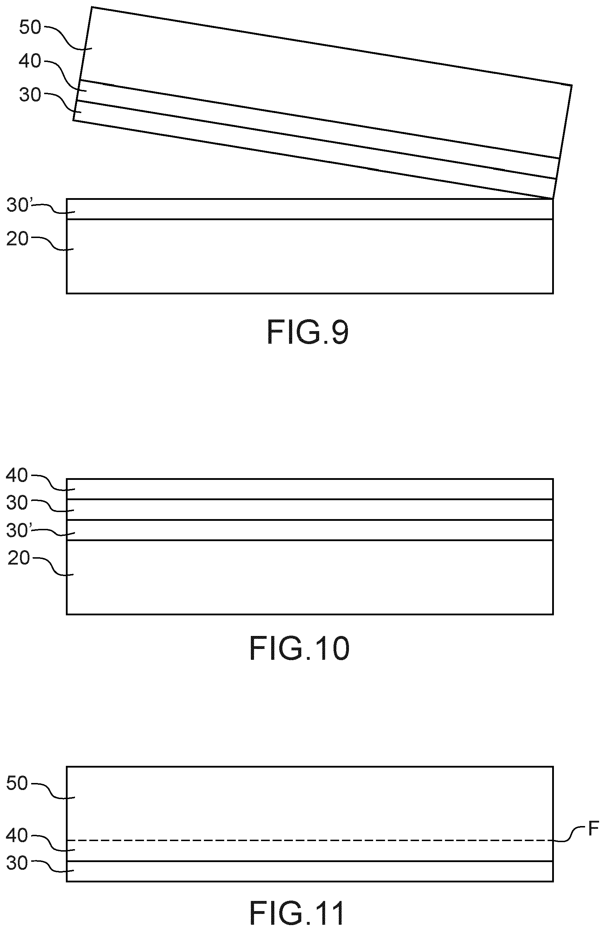

Ainsi, selon ces conditions, le report de l'empilement peut comprendre les étapes suivantes :
- un assemblage du substrat donneur 50 et du substrat de silicium monocristallin 20 (figure 9), par mise en contact de la couche isolante 30 et de la couche de piégeage 30',
- un amincissement du substrat donneur de manière à ne conserver que la couche de matériau cristallin sur le substrat de silicium monocristallin (figure 10).

L'assemblage peut par exemple comprendre un collage moléculaire.

L'amincissement peut comprendre un amincissement par abrasion mécanique (« Mechanical Grinding » selon la terminologie Anglo-Saxonne) ou chimico-mécanique (CMP « Chemical Mechanical Polishing » selon la terminologie Anglo-Saxonne).

Le report peut, de manière alternative, impliquer le procédé dit « SmartCut® » et décrit dans le document FR 2681472.

En particulier, l'assemblage peut être précédé de la formation d'une zone de fragilisation F qui délimite la couche de matériau monocristallin 40 au sein du substrat donneur 40 (figure 11). De manière particulièrement avantageuse la zone de fragilisation F est formée par implantation d'espèces chimique, et notamment par implantation d'hydrogène.

Selon ces conditions, l'amincissement peut comprendre une fracture qui se propage le long de la zone de fragilisation F. De manière particulièrement avantageuse, la fracture peut être initiée par un second traitement thermique.

L'invention n'est cependant pas limitée à la seule formation de la couche isolante 30 en recouvrement de la couche de matériau monocristallin avant l'étape de report.

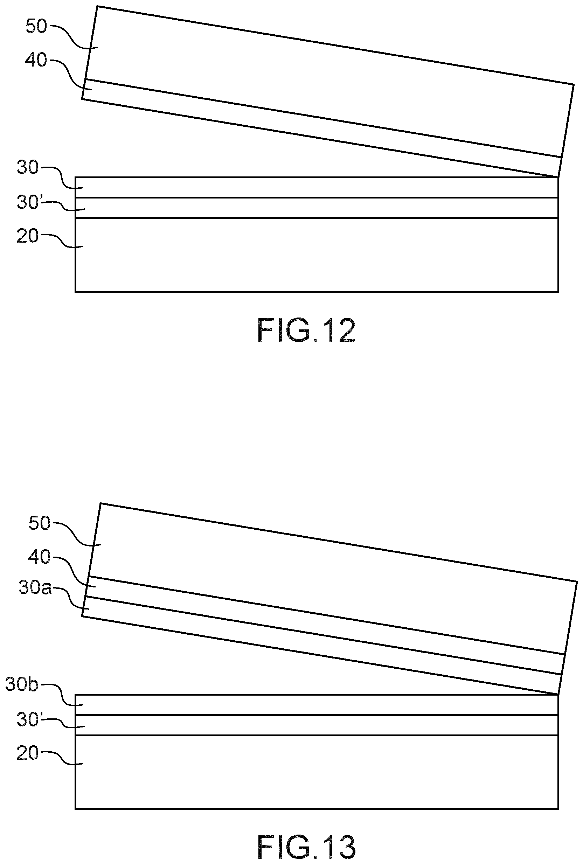

En effet, et de manière alternative, la couche isolante 30 peut être formée en recouvrement de la couche de piégeage 30' avant l'assemblage. Dans ces conditions, et tel qu'illustré à la figure 12, l'assemblage du substrat donneur 50 et du substrat de silicium monocristallin comprend la mise en contact de la couche isolante 30 avec la couche de matériau monocristallin 40.

Toujours de manière alternative, la couche isolante 30 peut comprend un empilement d'une première couche isolante 30a et d'une deuxième couche isolante 30b formées en recouvrement, respectivement, de la couche de matériau monocristallin 40 et de la couche de piégeage 30' avant assemblage. Dans ces conditions, et tel qu'illustré à la figure 13, l'assemblage du substrat donneur 50 et du substrat de silicium monocristallin 20 comprend la mise en contact de la première couche isolante 30a et de la deuxième couche isolante 30b.

Il est entendu que tous les aspects et alternatives présentés dans la présente invention peuvent être combinés entre eux.

L'invention ainsi décrite permet de considérer des substrats structurés pourvus d'une couche de piégeage à plus forte densité de défauts. Cet aspect permet ainsi de réduire l'épaisseur de la couche de piégeage.

Un tel procédé est alors avantageusement mis en œuvre pour la fabrication d'un substrat structuré du type SOI HR destiné à des applications RF, et plus particulièrement pour la co-intégration de dispositifs RF et de composants logiques.

### RÉFÉRENCES

[1] TakuyaNishikawa et al., "Electrical properties of polycrystalline silicon films formed from amorphous silicon films by flash lamp annealing", Current Applied Physics, Vol. 11, issue 3, pages 604-607, May 2011.

## Revendications

1. Procédé de fabrication d'un substrat structuré (10) pourvu d'une couche de piégeage (30') sur laquelle repose un empilement formé, dans l'ordre et à partir de ladite couche de piégeage (30'), d'une couche isolante (30) et d'une couche de matériau monocristallin (40), le procédé comprenant les étapes suivantes :
a) une étape de formation d'une couche de silicium amorphe (25) qui s'étend à partir d'une face avant (21) d'un substrat de silicium (20) selon une épaisseur E inférieure à 500 nm, avantageusement comprise entre 50 nm et 200 nm,
b) une étape de traitement thermique destinée à convertir la couche de silicium amorphe (25) en une couche de piégeage (30') formée de grains monocristallins de silicium soudés entre eux par des joints de grains et d'une taille inférieure à 200 nm, de préférence inférieure à 100 nm,
c) une étape de formation d'un empilement en recouvrement de la couche de piégeage (30'), et formé, dans l'ordre et à partir de ladite couche de piégeage (30'), d'une couche isolante (30) et d'une couche de matériau monocristallin (40).

2. Procédé selon la revendication 1, dans lequel l'étape b) est exécutée au moyen d'un rayonnement laser, avantageusement le rayonnement laser est un rayonnement laser à impulsions dont les impulsions sont d'une durée comprise entre 1 ns et 1 µs, d'une fluence comprise entre 10 J/cm² et 300 J/cm², et d'une longueur d'onde comprise entre 200 nm et 1100 nm.

3. Procédé selon la revendication 1 ou 2, dans lequel les conditions de traitement thermique de l'étape b) en termes de durée et de température sont ajustées de manière à limiter la taille T des grains à une taille inférieure à 200 nm, de préférence inférieure à 100 nm.

4. Procédé selon l'une des revendications 1 à 3, dans lequel la couche de silicium amorphe (25) est formée, lors de l'étape a), par une implantation d'amorphisation, d'espèces amorphisantes, destinée à amorphiser le substrat de silicium (20) à partir de sa face avant (21) et selon une profondeur d'implantation égale à l'épaisseur E.

5. Procédé selon la revendication 4, dans lequel les espèces amorphisantes comprennent :
- des ions germanium, de sorte que lors l'étape b) de traitement thermique de l'oxyde de germanium se forme au niveau des joints de grains,
et/ou
- des ions carbone destinés à favoriser également la formation de grains de taille T inférieure à 200 nm, de préférence inférieure à 100 nm, lors de l'exécution de l'étape b),
et/ou
- des espèces présentant une affinité chimique avec le silicium de manière à former avec ce dernier des précipités ou des complexes s'agrégeant au niveau des joints de grains lors de l'exécution de l'étape b).

6. Procédé selon l'une des revendications 1 à 5, dans lequel l'étape c) est précédée d'une étape a3) d'aplanissement de la couche de silicium amorphe (25), l'étape a3) étant avantageusement exécutée par polissage mécanochimique.

7. Procédé selon l'une des revendications 1 à 6, dans lequel, lors de l'exécution de l'étape c), la formation de la couche de matériau monocristallin (40) comprend un report de ladite couche de matériau monocristallin (40) à partir d'un substrat donneur.

8. Procédé selon la revendication 7, dans lequel le report comprend dans l'ordre :
- un assemblage du substrat donneur et du substrat de silicium (20) monocristallin,
- un amincissement du substrat donneur de manière à ne conserver que la couche de matériau cristallin sur le substrat de silicium (20) monocristallin.

9. Procédé selon la revendication 8, dans lequel l'amincissement du substrat donneur comprend un amincissement par abrasion mécanique.

10. Procédé selon la revendication 9, dans lequel l'assemblage du substrat donneur et du substrat de silicium (20) est précédé de la formation d'une zone de fragilisation qui délimite la couche de matériau monocristallin (40) au sein du substrat donneur, avantageusement la zone de fragilisation est formée par implantation d'espèces chimique, et notamment par implantation d'hydrogène et/ou d'hélium.

11. Procédé selon la revendication 10, dans lequel l'amincissement comprend une fracture qui se propage le long de la zone de fragilisation, ladite fracture étant avantageusement initiée par un second traitement thermique.

12. Procédé selon l'une des revendications 8 à 11, dans lequel l'assemblage est précédé de la formation de la couche isolante (30) sur l'une et/ou l'autre de la couche de piégeage (30') et de la couche de matériau monocristallin (40).

13. Procédé selon l'une des revendications 1 à 12, dans lequel la couche de matériau monocristallin (40) comprend au moins un des éléments choisi parmi : silicium, germanium, alliage de silicium-germanium, carbure de silicium, un semi-conducteur III-V, un matériau piézoélectrique.

14. Substrat structuré (10) qui comprend :
- un couche de piégeage (30') qui s'étend à partir d'une face avant (21) d'un substrat de silicium (20) selon une épaisseur E inférieure à 500 nm, avantageusement comprise entre 50 nm et 200 nm, la couche de piégeage (30') comprenant des grains monocristallins de silicium soudés entre eux par des joints de grains, et d'une taille T inférieure à 200 nm, voire 100 nm,
- un empilement formé, dans l'ordre et à partir de ladite couche de piégeage (30'), d'une couche isolante (30) et d'une couche de matériau monocristallin (40).
